(19) Europäisches Patentamt

European Patent Office

Office européen des brevets

(11) **EP 1 727 158 A2**

(12) **EUROPÄISCHE PATENTANMELDUNG**

(43) Veröffentlichungstag:
29.11.2006 Patentblatt 2006/48

(51) Int Cl.:
*G21K 1/06* (2006.01)        *G03F 7/20* (2006.01)

(21) Anmeldenummer: 06010729.9

(22) Anmeldetag: 24.05.2006

(84) Benannte Vertragsstaaten:
AT BE BG CH CY CZ DE DK EE ES FI FR GB GR
HU IE IS IT LI LT LU LV MC NL PL PT RO SE SI
SK TR
Benannte Erstreckungsstaaten:
AL BA HR MK YU

(30) Priorität: 24.05.2005   US 683879 P

(71) Anmelder: Carl Zeiss SMT AG
73447 Oberkochen (DE)

(72) Erfinder:
• Wedowski, Marco
73431 Aalen (DE)
• Weiss, Markus
73431 Aalen (DE)
• Müllender, Stephan
73432 Aalen (DE)
• Trenkler, Johann
73527 Schwäbisch Gmünd (DE)
• Enkisch, Hartmut
73431 Aalen (DE)
• Sipos, Gisela
73430 (DE)
• Van Mierlo, Hubert Adriaan
3144 RA Maassluis (NL)
• Nijkerk, Michiel David
1057 JD Amsterdam (NL)
• Wieringa, Fokko Pieter
6661 RE Elst (Gelderland) (NL)

(74) Vertreter: Fuchs Mehler Weiss & Fritzsche
Patentanwälte
Söhnleinstrasse 8
65201 Wiesbaden (DE)

(54) **Optisches Element für Strahlung im EUV- und/oder weichen Röntgenwellenlängenbereich und ein optisches System mit mindestens einem optischen Element**

(57)    Es wird ein optisches Element, insbesondere ein normal-incidence-Kollektorspiegel, für Strahlung im EUV- und/oder weichen Röntgenwellenlängenbereich beschrieben. Das Element weist ein Substrat (2), eine Multilayerbeschichtung (3) mit einem optisch aktiven Bereich (6) und einen Kondensator (20) auf, der eine erste und eine zweite Kondensatorelektrode (25, 26) umfasst. Mindestens eine Schicht der Multilayerbeschichtung (3) dient als erste Kondensatorelektrode (25). Zwischen beiden Kondensatorelektroden (25, 26) ist mindestens eine dielektrische Schicht (11) vorgesehen. Es wird auch ein optisches System mit mindestens einem optischen Element beschrieben, das eine erste Elektrode (40) aufweist, die in der Nähe des optischen Elementes (1) angeordnet ist.

**Fig. 1**

EP 1 727 158 A2

**Beschreibung**

Die Erfindung betrifft ein optisches Element für Strahlung im EUV-und/oder weichen Röntgenwellenlängenbereich mit einem Substrat und mit auf dem Substrat aufgebrachter Multilayerbeschichtung mit einer der einfallenden Strahlung zugewandten Außenfläche, die einen optisch aktiven Bereich aufweist. Die Erfindung bezieht sich auch auf einen normal-incidence-Kollektorspiegel und auf ein optisches System mit mindestens einem solchen optischen Element.

Eines der Hauptprobleme der Lithographie mit EUV-Strahlung oder weicher Röntgenstrahlung (Wellenlängen z. B. zwischen 1 und 20 nm) ist die Kontamination auf molekularer Ebene der optischen Elemente, insbesondere der in Lithographievorrichtungen eingesetzten Multilayer-Spiegel, wie sie z. B. aus der DE 100 16 008 bekannt sind. Diese Oberflächendegradation führt zu Reflektivitätsverlusten und Abbildungsfehlern. Es herrschen im Wesentlichen zwei Prozesse vor. Ein Prozess besteht in der Oxidation der Oberfläche, bei der die Oberfläche irreversibel zerstört wird. Der andere Prozess besteht im Aufwachsen von Kohlenstoff. Dieser zweite Prozess ist reversibel.

Die Degradation der Oberfläche kann unter anderem durch auf die Oberfläche des optischen Elementes auftreffende Ionen oder Elektronen verursacht werden. Die Ionen werden durch Photoionisation der Restgasatmosphäre bzw. von zu Reinigungszwecken eingeleiteten Gasen durch die EUV- und weiche Röntgenstrahlung erzeugt. Bei den Elektronen handelt es sich zumeist um unter Bestrahlung austretende Sekundärelektronen.

Das Problem der Oberflächendegradation durch geladene Teilchen wird noch verstärkt, wenn zu Überwachungs- und/oder Reinigungszwecken mit Hilfe von Elektroden oder Gittern elektrische Felder im Bereich der optischen Elemente angelegt werden. Durch den resultierenden Beschuss mit Ionen oder Elektronen (je nach Ausrichtung des elektrischen Feldes) kommt es zu einer stärkeren Degradation.

Das Problem der Oberflächendegradation wird außerdem verstärkt, wenn das optische Element bei gepulster EUV- oder weicher Röntgenstrahlung eingesetzt wird. Bei jedem Strahlungspuls lädt sich die Spiegeloberfläche positiv auf, da Sekundärelektronen induziert werden. Insbesondere, wenn im Bereich der optischen Elemente elektrische Felder angelegt sind, werden die optischen Elemente nachteilig beeinflusst. Außerdem kann die Steilheit der Flanken der EUV-Pulse, die in der Größenordnung von 10 bis 100 ns liegt, zu elektromagnetischen Effekten führen, was sich nachteilig auf die gesamte Anordnung, in der das optische Element eingesetzt wird, auswirken kann.

Es wird vermutet, dass die Ladungsträger bei nichtgeerdeten optischen Elementen aufgrund des sich bei deren Austritt aus der Oberfläche aufbauenden elektrischen Potentials wieder auf die Oberfläche des optischen Elements zurückfallen.

Aus der JP 2003124111 A ist ein optisches Element mit einer Multilayerbeschichtung bekannt. Die bei Bestrahlung auftretenden Sekundärelektronen mit einer Energie von 100eV können auf benachbarte optische Elemente auftreffen und diese dadurch beeinträchtigen. Um diese Sekundärelektronen abzufangen, kann dieses bekannte optische Element geerdet werden oder zwischen dem optischen Element und der Gehäusewand kann eine Potentialdifferenz angelegt werden, wobei die Wand an den positiven Pol einer Spannungsquelle und eine Schicht des Multilayersystems an den negativen Pol der Spannungsquelle angeschlossen ist.

Es hat sich jedoch gezeigt, dass außer den Photoelektronen im Bereich von 100eV auch niederenergetische Sekundärelektronen im Bereich von 10eV auftreten, die den größten Anteil der Sekundärelektronen bilden und mit einer solchen Elektrodenanordnung nicht schnell genug erfasst werden können.

Ein weiteres Problem ist darin zu sehen, dass bei einer herkömmlichen Erdung der Multilayerbeschichtung die austretenden Sekundärelektronen nicht ausreichend schnell ersetzt werden können, was zu einer zunehmenden positiven Aufladung des optischen Elements führen kann.

Es ist daher Aufgabe der Erfindung, ein optisches Element bzw. ein optisches System mit mindestens einem optischen Element zur Verfügung zu stellen, mit dem einerseits niederenergetische Sekundärelektronen erfasst und andererseits die positive Aufladung des optischen Elementes verhindert wird.

Diese Aufgabe wird mit einem optischen Element nach Anspruch 1 gelöst. Das optische Element weist einen Kondensator auf, der eine erste und eine zweite Kondensatorelektrode umfasst, wobei mindestens eine Schicht der Multilayerbeschichtung als erste Kondensatorelektrode geschaltet ist und die zweite Kondensatorelektrode vorzugsweise außerhalb des optisch aktiven Bereichs auf der Außenfläche der Multilayerbeschichtung angeordnet ist, wobei zwischen der zweiten Kondensatorelektrode und der Außenfläche mindestens eine dielektrische Schicht vorgesehen ist.

Der Kondensator ist damit Bestandteil des optischen Elementes bzw. in das optische Element integriert. Dieses direkt auf dem optischen Element angeordnete kapazitive Element weist den Vorteil auf, dass in kurzer Zeit die mindestens eine Schicht der Multilayerbeschichtung mit Elektronen versorgt werden kann, wenn sich durch den Austritt der Sekundärelektronen die Multilayerbeschichtung positiv auflädt.

Die Multilayerbeschichtung kann beispielsweise aus einem Stapel von Mo-Si-Schichten bestehen, wovon mindestens eine Schicht, die auch die Außenschicht sein kann, als erste Kondensatorelektrode geschaltet ist. Die Multilayerbeschichtung kann z. B. mit einer Schutzschicht zum Vakuum abschließen, das aus einem oder mehreren Materialien der Gruppe Ce, Be, SiO, SiC, $SiO_2$, $Si_2N_4$, C, Y, $MoSi_2$, B, $Y_2O_3$, $MoS_2$, $B_4C$, BN, $Ru_XSi_Y$,

Zr, Nb, MoC, $ZrO_2$, $Ru_XMo_Y$, $Rh_XMo_Y$, $Rh_XSi_Y$ besteht.

Weitere Multilayerbeschichtungen können wie folgt aufgebaut sein:

$$Mo - B_4C - Si$$

$$Mo - Mo_XSi_Y - Si$$

Die dielektrische Schicht kann beispielsweise aus $SiO_2$, $Al_2O_3$ oder $Ta_2O_5$ bestehen.

Vorzugsweise besteht die zweite Kondensatorelektrode aus C, Ge, Co, W, Ta, Mo, Ni, Cr, V, Ti, Ir, Ru, Au, Pt und/oder Rh und/oder deren Verbindungen, Mischungen und/oder deren Legierungen. Besonders bevorzugt sind Au, Pt, Ru und Rh.

Die mindestens eine dielektrische Schicht und die darauf aufgebrachte zweite Kondensatorelektrode können ringförmig ausgebildet sein. Ein solcher Kondensatorring umgibt den optisch aktiven Bereich der Außenfläche der Multilayerbeschichtung. Bevorzugte Dicken und Breiten eines solchen Kondensatorrings auf der Außenfläche der Multilayerbeschichtung sind: Dicke 0,1 - 50 $\mu$m, Breite 0,1 - 50 mm.

Die Kapazität C des Kondensators beträgt vorzugsweise ≤500 nF, insbesondere 150 - 400 nF, insbesondere 250 - 350 nF.

Die Zeitkonstante des Kondensators beträgt vorzugsweise ≤10 $\mu$s, insbesondere 0,1 bis 10 $\mu$s, insbesondere 0,5 - 1,5, insbesondere 1 $\mu$s.

Insbesondere beim Einsatz des optischen Elementes mit gepulster Strahlung wird ein Kondensator mit einer Zeitkonstante bevorzugt, die gewährleistet, dass eine Entladung des optischen Elementes zwischen zwei Pulsen stattfinden kann. Bei Strahlungsimpulsen im Megahertzbereich haben sich daher Zeitkonstanten < 1 $\mu$s bewährt.

Es ist mindestens eine Zuleitung zu den Kondensatorelektroden vorgesehen, die vorzugsweise aus einem sogenannten "Flex-Foil" besteht. Diese sogenannten "Flex-Foils" sind dadurch gekennzeichnet, dass sie 0,5 - 5 cm breit, bevorzugt 1 cm breit sind und eine Dicke von 0,05 - 0,5 mm, bevorzugt von 0,1 mm aufweisen. Bei den "Flex-Foils" wird der Skin-Effekt ausgenutzt. Bei hohen Frequenzen bleibt der Ohm'sche Widerstand konstant. Es sind sehr geringe Zeitkonstanten erreichbar.

Die Zuleitung besitzt vorzugsweise eine Induktivität < 5 pH. Insbesondere beim Einsatz von gepulster Strahlung hat es sich als vorteilhaft herausgestellt, wenn die Zuleitung eine geringe Induktivität aufweist, was zu einer schnellen Antwortfunktion des Kondensators führt, so dass eine Entladung möglichst schnell erfolgen kann.

Die Zuleitung besitzt vorzugsweise einen Ohmschen Widerstand < 100 mΩ. Es hat sich als vorteilhaft erwiesen, wenn die Zuleitung insgesamt einen geringen Widerstand aufweist, weil dadurch die Nachlieferung der Elektronen möglichst schnell durchgeführt werden kann.

Vorzugsweise besitzt das optische Element eine Spannungsquelle, die vorzugsweise zwischen den Kondensatorelektroden geschaltet ist.

Vorzugsweise ist mindestens eine Kondensatorelektrode an eine Umschalteinrichtung angeschlossen, mit der die Kondensatorelektrode auf Masse, positives oder negatives Potential legbar ist. Mittels der Umschalteinrichtung kann der Kondensator auf beliebige Potentiale eingestellt werden, was insbesondere dann von Vorteil ist, wenn dem optischen Element weitere Elektroden zum Einfangen von positiv geladenen Ionen oder höherenergetischen Sekundärelektronen zugeordnet ist.

Vorzugsweise ist die Umschalteinrichtung an eine Steuereinheit angeschlossen, die ggf. eine Zeitschalteinrichtung aufweist. Dadurch ist es möglich, in regelmäßigen Zeitabständen Umschaltungen vorzunehmen.

Zwischen der Kondensatorelektrode und der Umschalteinrichtung kann mindestens eine Messeinrichtung angeordnet sein. Hierbei kann es sich beispielsweise um eine Strommesseinrichtung handeln, um den Strom der eingefangenen Sekundärelektronen zu messen oder um eine Spannungsmesseinrichtung.

Ein oder mehrere erfindungsgemäße optische Elemente können zu einem optischen System zusammengefasst werden, das z. B. für die Beleuchtung oder die Projektion, insbesondere von abzubildenden Strukturen, geeignet ist. Aus den optischen Systemen lassen sich Lithographiegeräte herstellen. Mit Hilfe derartiger Lithographiegeräte lassen sich Bauelemente lithographisch herstellen, indem mit Hilfe mindestens eines optischen Elementes bzw. optischen Systems und EUV- oder weichen Röntgenstrahlung Strukturen auf einem Substrat abgebildet werden.

Das optische System ist gekennzeichnet durch mindestens ein optisches Element mit Kondensator und durch mindestens eine erste Elektrode, die in der Nähe des optischen Elements angeordnet ist. Mittels der in der Nähe des optischen Elements angeordneten ersten Elektrode können je nach eingestelltem Potential höherenergetische Sekundärelektronen, z. B. solche mit 100eV, oder auch positiv geladene Ionen eingefangen werden.

Die erste Elektrode ist vorzugsweise ein in der Nähe des optischen Elements angeordnete Platte, Ring oder Gitter.

Es kann zusätzlich eine zweite Elektrode vorgesehen sein, die vorzugsweise räumlich weiter vom optischen Element entfernt angeordnet ist als die erste Elektrode. Durch die Kombination von mindestens zwei Elektroden, d. h. mindestens einer ersten und mindestens einer zweiten Elektrode, wird das Volumen, in dem sich ein starkes elektrisches Feld befindet, reduziert. Damit verringert sich auch die Wahrscheinlichkeit, dass sich aufgrund des elektrischen Feldes unerwünschte Effekte einstellen.

Vorzugsweise ist die zweite Elektrode ein das optische Element umgebendes Gehäuse und die erste Elektrode ein in der Nähe des optischen Elementes angeordnetes Gitter, Platte oder Ring.

Auch die erste bzw. zweite Elektrode besitzen Zuleitungen in Form von "Flex-Foils". Die erste bzw. zweite Elektrode können jeweils an eine Umschalteinrichtung angeschlossen sein, mit der die Elektroden auf Masse, positives oder negatives Potential legbar sind. Die Umschalteinrichtungen können an einer Steuereinheit angeschlossen sein. Zwischen der jeweiligen Elektrode und der Umschalteinrichtung kann mindestens eine Messeinrichtung vorgesehen sein.

Das oder die optischen Elemente sind, wie eingangs erwähnt, beispielsweise Spiegel mit einer Multilayerbeschichtung. Hiervon sind insbesondere auch "normal incidence"-Kollektorspiegel umfasst, wie beispielsweise in der WO 2005/031748 A1 beschrieben, deren Inhalt vollumfänglich in die vorliegende Anmeldung aufgenommen wird. Solche Kollektorspiegel weisen ebenfalls eine Multilayerbeschichtung zur Verbesserung der Reflektionseigenschaften auf. Da sie naturgemäß besonders nahe der Strahlungsquelle angeordnet sind, sind sie auch einer entsprechend großen Kontaminationsgefahr ausgesetzt. Daher findet die erfindungsgemäße Kondensatoranordnung besonders bevorzugt auch auf solche Kollektorspiegel Anwendung.

Beispielhafte Ausführungsformen der Erfindung werden nachfolgend anhand der Zeichnungen näher erläutert. Es zeigen:

Fig. 1     eine perspektivische Darstellung des optischen Elementes,

Figur 2     einen Vertikalschnitt durch das in Figur 1 gezeigte optische Element längs der Linie A-A zusammen mit einer ersten Elektrode;

Figur 3     ein optisches System in schematischer Darstellung und

Figur 4     den Aufbau eines Lithographiesystems mit einem Schwarzlicht-Kollektorsystem, aufweisend zwei erfindungsgemäße normal-incidence-Kollektorspiegel.

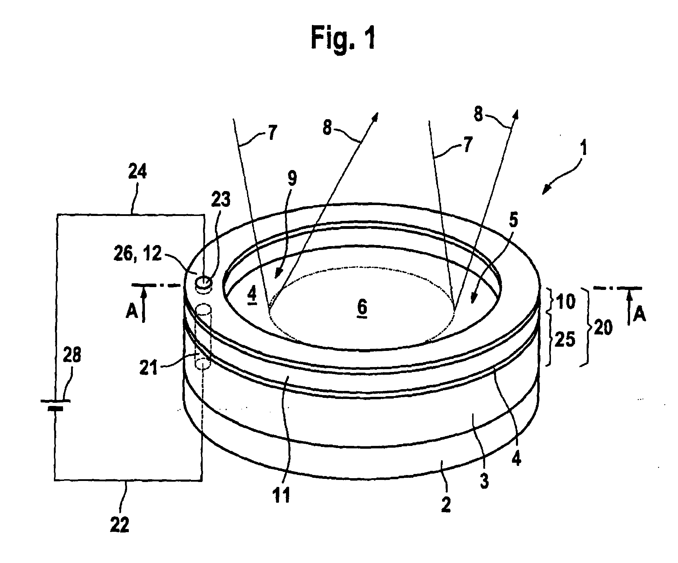

In der Fig. 1 ist ein optisches Element 1 dargestellt, das ein Substrat 2 aufweist, auf dem eine Multilayerbeschichtung in Form eines Multilayerpakets 3 aufgebracht ist. Auf diesem Multilayerpaket 3 ist eine Schutzschicht (cap layer) 4 vorgesehen, die die Außenfläche des optischen Elementes bildet.

Auf der Oberfläche 5 der Schutzschicht 4 ist ein Kondensatorring 10 angeordnet, der aus einer dielektrischen Schicht 11 und einer elektrisch leitenden Schicht 12 besteht. Dieser Kondensatoring 10 umschließt die optisch aktive Fläche 6, die durch die Strahlgeometrie definiert wird, wie sie durch die schematisch dargestellten einfallenden Strahlen 7 und reflektierten Strahlen 8 gekennzeichnet ist. Der ringförmige Randbereich zwischen optisch aktiver Fläche 6 und dem Kondensatorring 10 ist die optisch inaktive Fläche 9.

Das Multilayerpaket 3 mit der Schutzschicht 4 bildet die erste Kondensatorelektrode 25. Die elektrisch leitende Schicht 12 bildet die zweite Kondensatorelektrode 26. Zusammen mit der dielektrischen Schicht 11 wird der Kondensator 20 gebildet.

Die erste Kondensatorelektrode 25 besitzt ein erstes Kontaktelement 21, das sich in der hier gezeigten Ausführungsform durch das Multilayerpaket 3 und die Schutzschicht 4 erstreckt. Die zweite Kondensatorelektrode 26 besitzt ein zweites Kontaktelement 23, das innerhalb der elektrisch leitenden Schicht 12 angeordnet ist. Diese Kontaktelemente 21, 23 sind über Zuleitungen 22, 24 mit einer Spannungsquelle 28 verbunden, wobei diese Zuleitungen aus sogenannten Flex-Foils bestehen. Hierbei ist das erste Kontaktelement 21 mit dem negativen Pol und das zweite Kontaktelement 23 mit dem positiven Pol der Spannungsquelle 28 verbunden.

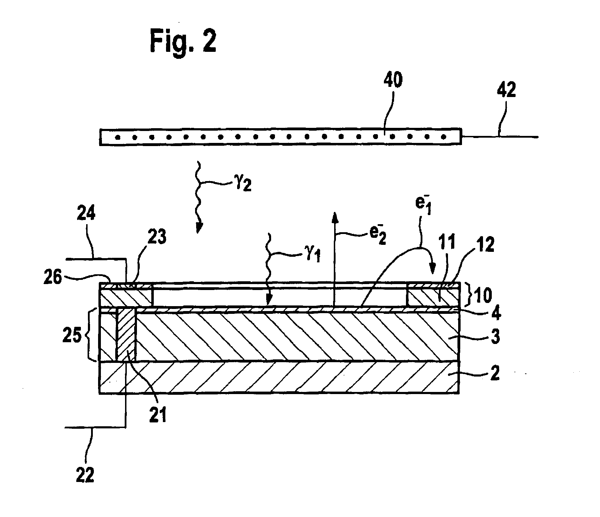

In der Figur 2 ist ein Schnitt durch das optische Element 1 gemäß der Figur 1 längs der Linie A-A dargestellt, wobei oberhalb des optischen Elementes 1 zusätzlich ein Gitter 40 eingezeichnet ist, das über eine Zuleitung 42 ebenfalls in Form eines Flex-Foils mit einer Spannungsquelle (nicht dargestellt) verbunden ist.

Auf die Oberfläche der Schutzschicht 4 treffen nacheinander Photonen ($\gamma_1$, $\gamma_2$) auf, die Sekundärelektronen erzeugen. Das Auftreffen des ersten Photons $\gamma_1$ kann sowohl Elektronen $e^-_1$ mit niedriger Energie (ca. 10eV) sowie hochenergetische Elektronen $e^-_2$ (ca. 100eV) erzeugen. Diese hochenergetischen Elektronen $e^-_2$ werden, wenn das Gitter 40 auf entsprechend positivem Potential liegt, von diesem Gitter eingefangen und über die Zuleitung 42 abgeleitet. Die niederenergetischen Elektronen $e^-_1$ werden aufgrund der Tatsache, dass die zweite Kondensatorelektrode 26, die sich gegenüber der ersten Kondensatorelektrode 25 auf positivem Potential befindet, angezogen. Durch die Entstehung der Sekundärelektronen $e^-_1$ und $e^-_2$ lädt sich die erste Kondensatorelektrode 25, insbesondere die Schutzschicht 4 positiv auf. Die für den Ladungsausgleich erforderlichen Elektronen werden über den Kondensator 20 in kürzester Zeit zugeführt, so dass sich die ursprüngliche Vorspannung wieder einstellt, damit das nachfolgende Photon $\gamma_2$ die selben Potentiale an den beiden Kondensatorelektroden 25, 26 vorfindet.

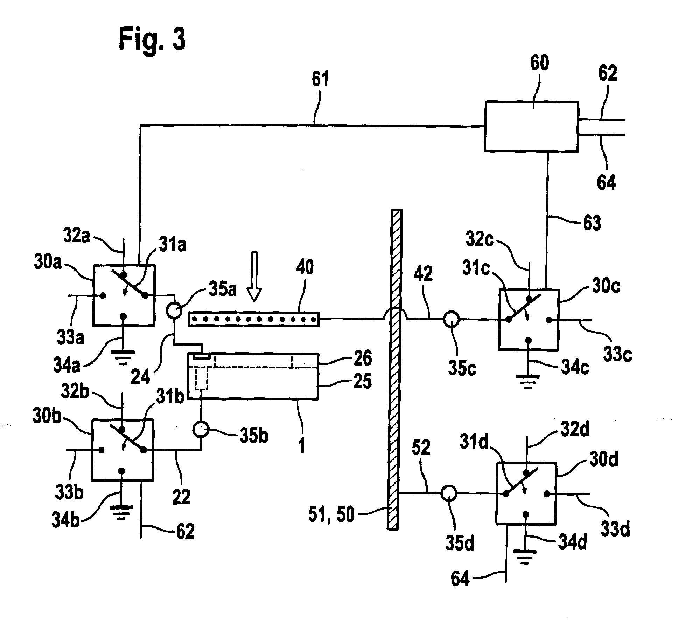

In der Fig. 3 ist eine schematische Darstellung eines optischen Systems zu sehen. Die erste Kondensatorelektrode 25 des optische Elements 1 ist über die Zuleitung 22 mit einem Umschalter 30b verbunden, wobei zwischen dem optischen Element 1 und dem Umschalter 30b eine Messeinrichtung 35b angeordnet ist.

Die zweite Kondensatorelektrode 26 ist über die Zuleitung 24 mit dem Umschalter 30a verbunden, wobei ebenfalls in der Zuleitung 24 eine Messeinrichtung 35a angeordnet ist.

Auch die erste Elektrode 40 ist in gleicher Weise mit einem Umschalter 30c und einer Messeinrichtung 35c verbunden. Eine zweite Elektrode 50 in Gestalt der Gehäusewand 51, die nur schematisch dargestellt ist, ist über eine Zuleitung 52 mit dem Umschalter 30d verbunden, wobei in der Zuleitung 52 eine Messeinrichtung 35d vorgesehen ist. Sämtliche Zuleitungen bestehen aus "Flex-Foils".

Jeder Umschalter ermöglicht mit den Schaltelementen 31a, b, c, d das Anlegen von Masse oder einem positiven bzw. negativen Potential. Die unterschiedlichen Potentiale liegen an den Anschlüssen 32a-d, 33a-d und 34a-d.

Sämtliche Umschalter 30a-d sind über entsprechende Zuleitungen 61-64 mit einer Steuereinrichtung 60 verbunden. Es wird dadurch möglich, ein schnelles Umschalten und somit einen schnellen Potentialwechsel an den einzelnen Komponenten vorzunehmen.

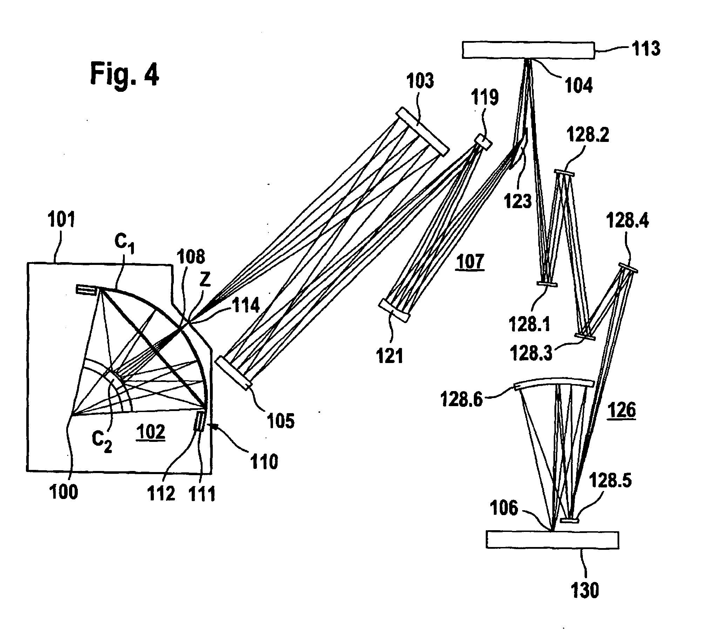

In Figur 4 wird der typische Aufbau eines EUV-Lithographiesystems für die Mikrolithographie dargestellt, welches ein Schwarzschild-Kollektorsystem 102 umfasst.

Die schematisch vereinfachte Darstellung des Schwarzschild-Kollektorsystems 102 zeigt einen ersten erfindungsgemäßen normal-incidence-Kollektorspiegel C1, der durch seine konkave, beispielsweise parabolische oder elliptische Ausformung Licht von der Lichtquelle 100 aufnimmt und auf den zweiten erfindungsgemäßen normal-incidence-Kollektorspiegel C2 zurückfaltet, der wiederum hyperbolisch oder ellipsoidförmig ausgebildet sein kann. Dieser zweite normal-incidence-Kollektorspiegel C2 ist so zentriert zum ersten normal-incidence-Kollektorspiegel C1 angeordnet, dass ein symmetrisches Kollektorsystem entsteht, welches die Lichtquelle 100 auf ein vergrößertes Zwischenbild Z abbildet. Für die vom zweiten normal-incidence-Kollektorspiegel C2 ausgehende Strahlung ist ein Durchgang 108 im ersten normal-incidence-Kollektorspiegel C1 vorgesehen. Demnach wird vom ersten normal-incidence-Kollektorspiegel C1 Licht von der Lichtquelle 100 mit einem ersten Aperturwinkel aufgenommen und mit einem zweiten Aperturwinkel zum zweiten normal-incidence-Kollektorspiegel C2 abgestrahlt. Dem vom zweiten normal-incidence-Kollektorspiegel C2 ausgehende Strahlbüschel wird wiederum ein dritter Aperturwinkel zugeordnet. Unter Aperturwinkel wird in der vorliegenden Anmeldung der Winkel zwischen dem Randstrahl eines Strahlenbüschels mit dem maximalen Strahlwinkel zur optischen Achse verstanden. Die Aperturwinkel definieren zugleich den optisch aktiven Bereich der Kollektorspiegel C1 und C2. Bei den bei EUV-Beleuchtung vorliegenden Vakuumbedingungen ergibt sich dann die numerische Apertur aus den Sinus des Aperturwinkels.

Der Kollektorspiegel C1 ist aus einer Multilayer-Beschichtung aufgebaut, wie das optische Element 1 aus Figur 1. Wie dort, befindet sich auf einer (nicht dargestellten) Schutzschicht.ein Kondensatorring 110, der wiederum aus einer dielektrischen Schicht 111 und einer elektrisch leitenden Schicht 112 besteht. Dieser Kondensatorring 110 umschließt die optisch aktive Fläche des Kollektors dergestalt, dass er vollständig außerhalb des ersten und des zweiten Aparturwinkels angeordnet ist, wie durch die schematisch dargestellten einfallenden und reflektierenden Strahlen gekennzeichnet ist.

In analoger Weise ist auch der zweite normal-incidence-Kollektorspiegel C2 mit einer Multilayer-Beschichtung und einem auf deren Schutzschicht angeordneten Kondensatorring versehen. Beides ist in Figur aus Maßstabsgründen nicht erkennbar. Abermals umschließt der Kondensatorrings des Kollektors C2 die durch die Strahlengeometrie definierte optische Fläche dergestalt, dass weder der zweite noch der dritte Aparturwinkel hierdurch beeinträchtigt werden.

Des Weiteren gezeigt in Figur 4 sind im Lichtweg ausgehend von einer Lichtquelle 100 zu einer ausgeleuchteten Ebene, die als Feldebene 113 bezeichnet wird, optische Komponenten eines Beleuchtungssystems sowie des Projektionsobjektiv 126 einer Projektionsbelichtungsanlage.

Die Ausbildung eines Zwischenbilds Z der Lichtquelle 100 ist von Vorteil, da es so möglich ist, die Lichtquelle 100 und das Kollektorsystem 102 in ein vom nachfolgenden System atmosphärisch getrenntes Kompartiment einzuschließen. Ein solches Kompartiment ist in Figur 4 skizziert und mit dem Bezugzeichen 101 versehen. Außerdem ist es aufgrund der Ausbildung des Zwischenbilds Z der Lichtquelle 100 möglich, eine Blende 114, welche beispielsweise mit einem Gütterspektralfilter für die spektrale Filterung der Beleuchtung zusammenwirkt, in den Strahlengang aufzunehmen.

Des Weiteren sind in Figur 4 die dem erfindungsgemäßen Kollektorsystem 102 im Lichtweg von der Lichtquelle 100 zur ausgeleuchteten Feldebene 113 nachgeordneten optischen Komponenten des Beleuchtungssystems sowie das Projektionsobjektiv 126 gezeigt. Im Einzelnen ist in Figur 4 folgendes dargestellt: Ein Retikel bzw. eine Maske 104 wird in der Feldebene 113 eines Projektionsbelichtungssystems positioniert und mittels einer Reduktionsoptik 126 auf dessen Bildebene 130 abgebildet, in der sich typischerweise ein mit einem lichtempfindlichen Material versehener Wafer 106 befindet. Figur 4 zeigt hierzu beispielhaft ein Projektionsobjektiv bestehend aus sechs Einzelspiegeln 128.1 bis 128.6, das beispielsweise aus der US 6 600 552, die vollumfänglich in die vorliegende Anmeldung mit aufgenommen wird, hervorgeht. Skizziert ist ferner eine im Idealfall tlezentrische Beleuchtung der Bildebene 130, d. h. der Hauptstrahl eines Strahlenbüschels, welcher von einem Feldpunkt der Feldebene 113 ausgeht, schneidet die Bildebene 130 senkrecht. Ferner weist das Projektionsobjektiv 126 eine Eintrittspupille auf, die im Allgemeinen, mit der Austrittspupille des Beleuchtungssystems zusammenfällt.

Figur 4 zeigt außerdem den typischen Aufbau eines EUV-Beleuchtungssystems, welches als doppeltfacettiertes Beleuchtungssystem gemäß der US 6 198 793 B1 ausgebildet wird, wobei der Inhalt dieses Dokuments vollumfänglich in die vorliegende Anmeldung mit aufgenommen wird. Ein solches System umfasst ein erstes optisches Element mit ersten Rasterelementen 103, welches auch als Feldfacettenspiegel 103 bezeichnet wird. Im Strahlengang anschließend folgt ein zweites optisches Element mit zweiten Rasterelementen 105, das üblicherweise Pupillenfacettenspiegel 105 genannt wird.

Feld und Pupillenfacettenspiegel 103, 105 dienen zur Ausleuchtung eines Felds in der Feldebene 113 sowie der Gestaltung der Ausleuchtung in der Austrittspupille des Beleuchtungssystems. Die Wirkung jeder Feldwabe ist dergestalt, dass die ein Bild der Lichtquelle 100 ausbildet, wobei durch die Vielzahl Feldfacetten eine Vielzahl von so genannten sekundären Lichtquellen gebildet wird. Die sekundären Lichtquellen werden in oder nahe der Ebene, in welcher der Pupillenfacettenspiegel 105 angeordnet ist, ausgebildet. Damit, wie in Figur 4 dargestellt, die sekundären Lichtquellen im Bereich des Pupillenfacettenspiegels 105 zu liegen kommen, können die Feldfacetten selbst eine optische Wirkung, beispielsweise eine sammelnde optische Werkung, aufweisen. Von den nachfolgenden optischen Elementen werden diese sekundären Lichtquellen als tertiäre Lichtquelle in die Austrittspupille des Beleuchtungssystems abgebildet.

Ferner wird jede Feldwabe durch die Facetten des Pupillenfacettenspiegels 105 und den nachfolgenden optischen Elementen der zweiten optischen Komponente 107, die im Beispiel aus Figur 4 aus den drei optischen Elementen erstes reflektives optisches Element 119, zweites reflektives optisches Element 121 und den grazing-incidence-Spiegel 123 bestehen, in die Feldebene 113 abgebildet. Die sich dort überlagemden Bilder der Feldfacetten dienen zur Ausleuchtung einer Maske 104 in der Feldebene 113, wobei typischerweise, ausgehend von rechteckförmigen oder bogenförmigen Feldfacetten, eine Ausleuchtung in der Feldebene 113 in der Form eines Ringfeldsegments entsteht. Im Allgemeinen ist das Mikrolithographiesystem als scannendes System ausgebildet, so dass die Maske 104 in der Feldebene 113 und eine Wafer 106 in die Bildebene 130 synchron bewegt werden, um eine Ausleuchtung bzw. eine Belichtung zu bewirken.

**Bezugzeichenliste**

1    optisches Element
2    Substrat
3    Mulitlayerpaket
4    cap layer
5    Oberfläche des cap layers

6    optisch aktive Fläche
7    einfallender Strahl
8    reflektierter Strahl
9    optisch inaktive Fläche

10   Kondensatorring
11   Dielektrische Schicht
12   elektrisch leitende Schicht

20   Kondensator
21   erstes Kontaktelement
22   Zuleitung
23   zweites Kontaktelement
24   Zuleitung
25   erste Kondensatorelektrode
26   zweite Kondensatorelektrode

30a-d   Umschalteinrichtung
31 a-d  Schalter
32a-d   Anschluss positives Potential
33a-d   Anschluss negatives Potential
34a-d   Masse-Anschluss
35a-d   Messeinrichtung

40   Gitter
42   Zuleitung
50   zweite Elektrode
51   Gehäusewand
52   Zuleitung
60   Steuereinrichtung
61   Verbindungsleitung
62   Verbindungsleitung
63   Verbindungsleitung
64   Verbindungsleitung

100  Lichtquelle
101  Kompartiment zum Einschluss der Lichtquelle 100 und des Kollektorsystems 102
102  Kollektorsystem
103  erstes optisches Element mit ersten Rasterelementen (Feldfacettenspiegel)
104  strukturtragende Maske
105  zweites optisches Element mit ersten Rasterelementen (Pupillenfacettenspiegel)
106  mit einem lichtempfindlichen Material versehener Wafer
107  zweite optische Komponente
108  Durchgang im ersten normal-incidence Spiegel
110  Kondensatorring
111  Dielektrische Schicht
112  elektrisch leitende Schicht
113  Feldebene
114  Blende
119  erstes reflektives optisches Element

121 zweites reflektives optisches Element
123 grazing-incidence Spiegel
126 Projektionsobejtiv
128.1, 128.2, Spiegel des Projektionsobjektiv
128.3, 128.4,
128.5, 128.6
130 Bildebene

C1 erster normal-incidence-Kollektorspiegel
C2 zweiter normal-incidence-Kollektorspiegel

**Patentansprüche**

1. Optisches Element (1, C1, C2) für Strahlung im EUV- und/oder weichen Röntgenwellenlängenbereich mit einem Substrat (2) und mit auf dem Substrat (2) aufgebrachter Multilayerbeschichtung (3) mit einer der einfallenden Strahlung zugewandten Außenfläche (5), die einen optisch aktiven Bereich (6) aufweist, **gekennzeichnet durch** einen Kondensator (20), der eine erste und eine zweite Kondensatorelektrode (25, 26, 112) umfasst, wobei mindestens eine Schicht der Multilayerbeschichtung (3) als erste Kondensatorelektrode (25) dient und wobei zwischen der ersten Kondensatorelektrode (25) und der zweiten Kondensatorelektrode (26, 112) mindestens eine dielektrische Schicht (11, 111) vorgesehen ist.

2. Optisches Element (1, C1, C2) nach Anspruch 1, **dadurch gekennzeichnet, dass** die zweite Kondensatorelektrode (26, 112) und die dielektrische Schicht (11, 111) außerhalb des optisch aktiven Bereichs (6) angeordnet sind.

3. Optisches Element (1, C1, C2) nach einem der Ansprüche 1 oder 2, **dadurch gekennzeichnet, dass** die dielektrische Schicht (11, 111) und die zweite Kondensatorelektrode (26, 112) auf der Außenfläche (5) der Multilayerbeschichtung (3) angeordnet sind.

4. Optisches Element (1, C1, C2) nach einem der Ansprüche 1 bis 3, **dadurch gekennzeichnet; dass** die dielektrische Schicht (11, 111) aus $SiO_2$, $Al_2O_3$ oder $Ta_2O_5$ besteht.

5. Optisches Element (1, C1, C2) nach einem der Ansprüche 1 bis 4, **dadurch gekennzeichnet, dass** die zweite Kondensatorelektrode (26, 112) aus C, Ge, Co, W, Ta, Mo, Ni, Cr, V, Ti, Ir, Ru, Au, Pt und/oder Rh und/oder deren Verbindungen, Mischungen und/oder deren Legierungen besteht.

6. Optisches Element (1, C1, C2) nach einem der Ansprüche 1 bis 5, **dadurch gekennzeichnet, dass** die mindestens eine dielektrische Schicht (11, 111) und die zweite Kondensatorelektrode (26, 112) ringförmig ausgebildet sind.

7. Optisches Element (1, C1, C2) nach einem der Ansprüche 1 bis 6, **dadurch gekennzeichnet, dass** die Kapazität C des Kondensators (20) 150 - 400 nF beträgt.

8. Optisches Element (1, C1, C2) nach einem der Ansprüche 1 bis 7, **dadurch gekennzeichnet, dass** die Zeitkonstante des Kondensators (20) 0,1 bis 10 $\mu$s beträgt.

9. Optisches Element (1, C1, C2) nach einem der Ansprüche 1 bis 8, **dadurch gekennzeichnet, dass** mindestens eine Zuleitung (22, 24) zu den Kondensatorelektroden vorgesehen ist, welche aus einer Flex-Foil besteht.

10. Optisches Element (1, C1, C2) nach Anspruch 9, **dadurch gekennzeichnet, dass** die Zuleitung (22, 24) eine Induktivität < 5 $\mu$H aufweist.

11. Optisches Element (1, C1, C2) nach einem der Ansprüche 9 oder 10, **dadurch gekennzeichnet, dass** die Zuleitung (22, 24) einen Ohmschen Widerstand < 100 m$\Omega$ aufweist.

12. Optisches Element (1, C1, C2) nach einem der Ansprüche 1 bis 11, **dadurch gekennzeichnet, dass** eine Spannungsquelle (28) vorgesehen ist.

13. Optisches Element (1, C1, C2) nach einem der Ansprüche 1 bis 12, **dadurch gekennzeichnet, dass** mindestens eine Kondensatorelektrode (25, 26, 112) an eine Umschalteinrichtung (30a, b) angeschlossen ist, mit der die Kondensatorelektrode (25, 26, 112) auf Masse, positives oder negatives Potential legbar ist.

14. Optisches Element (1, C1, C2) nach einem der Ansprüche 1 bis 13, **dadurch gekennzeichnet, dass** die Umschalteinrichtung (30a, b) an eine Steuereinheit (60) angeschlossen ist.

15. Optisches Element (1, C1, C2) nach einem der Ansprüche 1 bis 14, **dadurch gekennzeichnet, dass** zwischen der Kondensatorelektrode (25, 26, 112) und der Umschalteinrichtung (30a, b) mindestens eine Messeinrichtung (35a, b), insbesondere für Stromstärke oder Spannung, angeordnet ist.

16. Optisches Element (1, C1, C2) nach einem der vorstehenden Ansprüche, **dadurch gekennzeichnet, dass** das optische Element ein normal-incidence-Kollektorspiegel (C1, C2) ist.

17. Optisches System **gekennzeichnet durch** mindestens ein optisches Element (1, C1, C2) nach einem der Ansprüche 1 bis 16 und **durch** mindestens eine erste Elektrode (40), die in der Nähe des optischen Elementes (1, C1, C2) angeordnet ist.

**18.** Optisches System nach Anspruch 17, **dadurch gekennzeichnet, dass** die erste Elektrode (40) ein in der Nähe des optischen Elementes (1, C1, C2) angeordnete Platte, Ring oder Gitter ist.

**19.** Optisches System nach einem der Ansprüche 17 oder 18, **dadurch gekennzeichnet, dass** eine zweite Elektrode vorgesehen ist.

**20.** Optisches System nach einem der Ansprüche 17 bis 19, **dadurch gekennzeichnet, dass** mindestens eine zweite Elektrode vorgesehen ist, die räumlich weiter vom optischen Element (1, C1, C2) entfernt angeordnet ist als die erste Elektrode (40).

**21.** Optisches System nach einem der Ansprüche 17 bis 20, **dadurch gekennzeichnet, dass** die zweite Elektrode eine das optische Element umgebende Gehäusewand (50, 101) ist und dass die erste Elektrode (40) ein in der Nähe des optischen Elementes angeordnetes Gitter, Platte oder Ring ist.

**22.** Optisches System nach einem der Ansprüche 17 bis 21, **dadurch gekennzeichnet, dass** die Zuleitungen (42, 52) der Elektroden (40, 50) aus Flex-Foils bestehen.

**23.** Optisches System nach einem der Ansprüche 17 bis 22, **dadurch gekennzeichnet, dass** mindestens eine der Elektroden (40, 50) an eine Umschalteinrichtung (30c, 30d) angeschlossen ist, mit der die Elektroden (40, 50) auf Masse, positives oder negatives Potential legbar sind.

**24.** Optisches System nach einem der Ansprüche 17 bis 23, **dadurch gekennzeichnet, dass** die Umschalteinrichtung (30c, d) an eine Steuereinheit (60) angeschlossen ist.

**25.** Optisches System nach einem der Ansprüche 17 bis 24, **dadurch gekennzeichnet, dass** zwischen der Elektrode (40, 50) und der Umschalteinrichtung (30c, d) jeweils mindestens eine Messeinrichtung (35c, 35d), insbesondere für Stromstärke oder Spannung, angeordnet ist.

**26.** Optisches System nach einem der Ansprüche 17 bis 25, **dadurch gekennzeichnet, dass** das optische Element ein normal-incidence-Kollektorspiegel (C1, C2) ist.

# Fig. 1

# Fig. 2

## Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10016008
- JP 2003124111 A
- WO 2005031748 A1
- US 6600552 B
- US 6198793 B1